**Europäisches Patentamt**

**European Patent Office**

**Office européen des brevets**

(19)

(11) **EP 1 531 464 A2**

(12) # EUROPEAN PATENT APPLICATION

(43) Date of publication:
**18.05.2005 Bulletin 2005/20**

(51) Int Cl.⁷: **G11B 7/0065**, G11C 13/04

(21) Application number: **04257077.0**

(22) Date of filing: **16.11.2004**

(84) Designated Contracting States:
**AT BE BG CH CY CZ DE DK EE ES FI FR GB GR
HU IE IS IT LI LU MC NL PL PT RO SE SI SK TR**
Designated Extension States:
**AL HR LT LV MK YU**

(30) Priority: **17.11.2003 JP 2003387055**

(71) Applicant: **Alps Electric Co., Ltd.
Tokyo 145 (JP)**

(72) Inventors:
• **Mitsuya, Shinji, c/o Alps Electric Co., Ltd.
Ota-ku, Tokyo (JP)**
• **Someno, Yoshihiro, c/o Alps Electric Co., Ltd.
Tokyo (JP)**

(74) Representative: **Kensett, John Hinton
Saunders & Dolleymore,
9 Rickmansworth Road
Watford, Hertfordshire WD18 0JU (GB)**

(54) **Holographic memory reproducing device**

(57)    A holographic memory reproducing device (1) includes a laser oscillator (20) for emitting multimode laser light to be incident on a holographic storage medium (10). The laser light of a main mode has a half-width such that the wavelength distribution of the main mode is continuous with the wavelength distributions of the two adjacent side modes and such that the laser light has a continuous wavelength distribution over the main mode and all the side modes.

## FIG. 1

EP 1 531 464 A2

## Description

## BACKGROUND OF THE INVENTION

### 1. Field of the Invention

The present invention relates to a holographic memory device for reproducing information by illuminating a holographic storage medium with laser light, and more specifically, to a holographic memory device for illuminating a holographic storage medium with laser light having a wide wavelength band.

### 2. Description of the Related Art

Memory devices that magnetically or optically record or reproduce information onto or from storage media in two dimensions have been widely used for computers or the like. Examples of such magnetic memory devices include a floppy (trademark) disk or a hard disk, and examples of such optical memory devices include a CD or DVD. To respond to market demand for higher memory capacity, these memory devices have achieved high storage density. Now, for even higher memory capacity, novel memory devices utilizing holography are being developed.

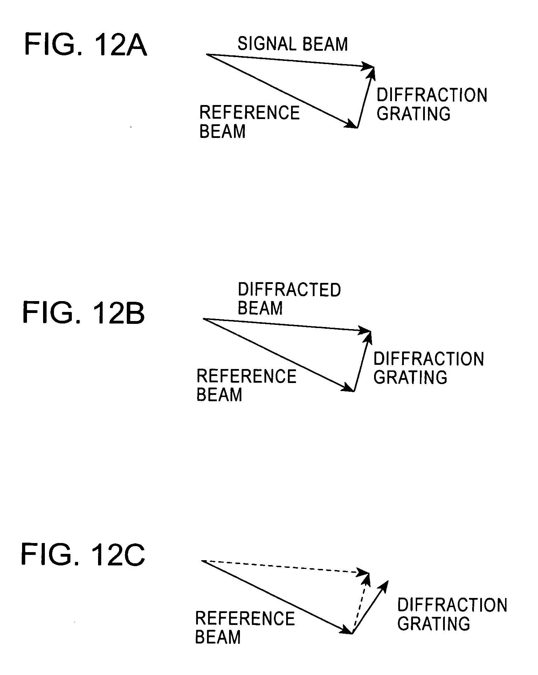

Holographic memory devices record and reproduce information per page with a signal beam and a reference beam of laser light, as typically described in Japanese Unexamined Patent Application Publication No. 2003-43904. To record information, a signal beam having encoded information for a page is made incident on a holographic storage medium and the signal beam interferes with a reference beam on the holographic storage medium. The interference pattern is recorded on the holographic storage medium as a diffraction grating, and this is represented by vectors in Fig. 12A. A vector for a signal beam (signal-beam vector), a vector for a reference beam (reference-beam vector), and a vector for a diffraction grating (diffraction-grating vector) form a closed triangle.

To reproduce information recorded on the holographic storage medium, a reference beam is made incident on the holographic storage medium at the same angle as that of a reference beam used to record the information. The reference beam incident on the holographic storage medium is diffracted at the diffraction grating recorded on the holographic storage medium. Since the diffracted light has the same wavefront as the signal beam used for recording, the information is reproduced by detecting the diffracted light by, e.g., a CCD or a CMOS camera. Reproduction of the information is represented by vectors in Fig. 12B. A vector for the diffracted beam (diffracted-beam vector) identical to the signal-beam vector used for recording is reproduced by the reference-beam vector and the diffraction-grating vector.

Due to an external shock, deviation when installing the storage medium, or intrusion of dust, sometimes the position of the holographic storage medium is slightly deviated from its original position. In this case, the incident angle of the reference beam with respect to the holographic storage medium is different between recording and reproducing. Accordingly, the reference beam is not diffracted at the diffraction grating and thus diffracted light is never generated. Therefore, the wavefront of the signal beam used for recording cannot be reconstructed and thus the recorded information cannot be reproduced. This state is represented by the vectors shown in Fig. 12C. The diffracted-beam vector to be reproduced does not meet the reference-beam vector and the diffraction-grating vector, and so diffracted light cannot be generated. This is the same when the position of the laser oscillator is deviated.

## SUMMARY OF THE INVENTION

The present invention aims to solve the aforementioned problems and it is an object of the present invention to provide a holographic memory device that can correct deviation of incident laser light with respect to a holographic storage medium.

According to a first aspect of the present invention, a holographic memory device includes a laser oscillator for emitting multimode laser light to be incident on a holographic storage medium. In the holographic memory device, the laser light of a main mode has a half-width such that the wavelength distribution of the main mode is continuous with the wavelength distributions of the two adjacent side modes and such that the laser light has a continuous wavelength distribution over the main mode and all the side modes. Accordingly, when the positional relationship between the laser beam and the holographic storage medium becomes slightly out of balance and thus the incident angle of the laser beam is deviated, the deviation can be corrected due to the difference in the wavelength of the laser light.

Further, in the holographic memory device according to the first aspect of the present invention, preferably the laser oscillator includes a light resonator having reflectors, the reflectors having irregularities on the surfaces thereof so that the length of the resonator differs depending on position. In this holographic memory device, preferably, light is resonated depending on the different lengths of the resonator, whereby wavelength bands at the main mode and the side modes are increased. Accordingly, the wavelength distribution of the laser light emitted from the laser oscillator is continuous over the main mode and all the side modes.

Furthermore, in the holographic memory device according the first aspect of the present invention, preferably, the laser oscillator has a light resonator including multi-layered filters functioning as reflectors, each of the multi-layered filters having a flat and broad intensity distribution of reflected light in which the intensity of laser light gradually changes with a change in the thickness of the multi-layered filter so that the length of the resonator differs depending on position. In this holographic memory device, preferably, light is resonated depending on the different lengths of the resonator, whereby wavelength bands at the main mode and the side modes are increased. Accordingly, the wavelength distribution of the laser light emitted from the laser oscillator is continuous over the main mode and all the side modes.

Moreover, in the holographic memory device according to the first aspect of the present invention, preferably, the laser oscillator has a light resonator including multi-layered filters functioning as reflectors, each of the multi-layered filters having a thickness 1.5 times larger than or equal to a minimum thickness at which the multi-layered filter exhibits a predetermined intensity of reflected light so that the length of the resonator differs depending on position. In this holographic memory device, preferably, light is resonated depending on the different lengths of the resonator, whereby wavelength bands at the main mode and the side modes are increased. Accordingly, the wavelength distribution of the laser light emitted from the laser oscillator is continuous over the main mode and all the side modes.

Further, in the holographic memory device according to the first aspect of the present invention, preferably, the difference between the intensity of the main mode and the intensity of the two adjacent side modes is less than or equal to 20 dB, the intensity of the main mode being the highest intensity of the laser light. Accordingly, the laser light has a sufficient intensity at the wavelengths between the main mode and the two adjacent side modes.

Furthermore, according to a second aspect of the present invention, a holographic memory device includes a laser oscillator for emitting multimode laser light to be incident on a holographic storage medium. In this holographic memory device, the laser light has a flat and broad wavelength distribution in which the wavelength distribution of a main mode and the wavelength distributions of side modes are continuous. Accordingly, when the positional relationship between the laser beam and the holographic storage medium becomes slightly out of balance and thus the incident angle of the laser beam is deviated, the deviation can be corrected due to the difference in the wavelength of the laser light.

Furthermore, in the holographic memory device according to the second aspect of the present invention, preferably, the laser oscillator has a light resonator including reflectors, the reflectors having irregularities on the surfaces thereof so that the length of the resonator differs depending on position. In the holographic memory device, preferably, light is resonated depending on the different lengths of the resonator, whereby wavelength bands at the main mode and the side modes are increased. Accordingly, the laser light emitted from the laser oscillator has a wide and broad wavelength distribution in which the wavelengths at the main mode and the side modes are continuous.

Moreover, according to a third aspect of the present invention, a holographic memory device includes a laser oscillator for emitting multimode laser light to be incident on a holographic storage medium and a current modulator for generating a current whose amplitude changes in a predetermined range. In this holographic memory device, the current modulated by the current modulator is supplied to the laser oscillator to change the wavelength of the laser light in a predetermined range and the laser light with the modulated wavelength is emitted onto the holographic storage medium. Assuming that an oscillation during which laser light changes from a minimum wavelength to a maximum wavelength is one oscillation, the laser light emitted from a laser oscillator has a wavelength band from the minimum wavelength to the maximum wavelength. Accordingly, when the positional relationship between the laser beam and the holographic storage medium is slightly out of balance and thus the incident angle of the laser beam is deviated, the deviation of the incident angle can be corrected due to the difference in the wavelength of the laser beam.

Moreover, in the holographic memory device according to the first, second, and third aspects of the present invention, preferably, the wavelength range of the laser light emitted from the laser oscillator is shorter than each of the intervals of the wavelengths of laser beams used for recording the information by multiplexing. Accordingly, the laser light emitted from the laser oscillator is prevented from interfering with laser beams with different wavelength bands that are used for recording the information by wavelength multiplexing.

Embodiments of the invention will now be described, by way of example only, with reference to the accompanying drawings, in which:

Fig. 1 is a schematic view of a holographic memory device according to a first embodiment of the present invention;
Fig. 2 is a cross-sectional view of a semiconductor laser according to the first embodiment of the present invention;
Fig. 3 is an enlarged cross-sectional view of a cleavage plane and its vicinity;
Fig. 4 is a graph showing the spectrum of laser light emitted from the semiconductor laser according to the first embodiment;
Fig. 5 is a vector representation, showing correction of deviation of an incident angle by changing the wavelength of a reference beam;
Fig. 6 is a graph showing the spectrum wherein the wavelength distribution is continuous between each mode;
Fig. 7 is a schematic illustration showing an example of correction of deviation of an incident angle by varying the wavelength of the reference beam;
Fig. 8 is an enlarged cross-sectional view of an active layer of a semiconductor laser according to a second embodiment of the present invention;

Fig. 9 is a graph showing the intensity of light reflected by a multi-layered filter according to the second embodiment;

Fig. 10 is a schematic view of a holographic memory device according to a third embodiment of the present invention;

Fig. 11 is a graph showing the spectrum of laser light emitted from a semiconductor laser according to a third embodiment of the present invention;

Figs. 12A to 12C show states of recording/reproducing information to/from a holographic memory device by vectors; and

Fig. 13 is a graph showing an intensity distribution of light reflected by a multi-layered filter constituting a reflector in a known semiconductor laser.

## DESCRIPTION OF THE PREFERRED EMBODIMENTS

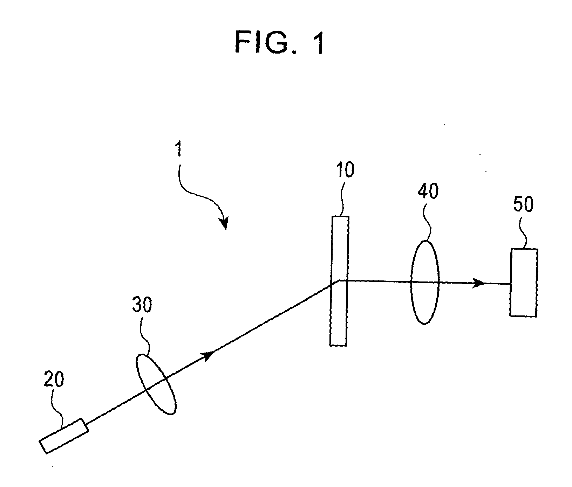

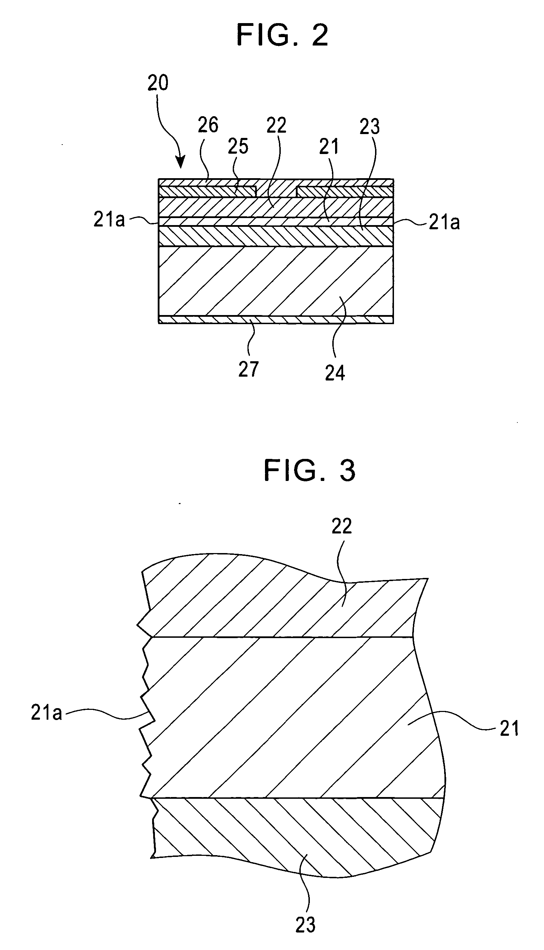

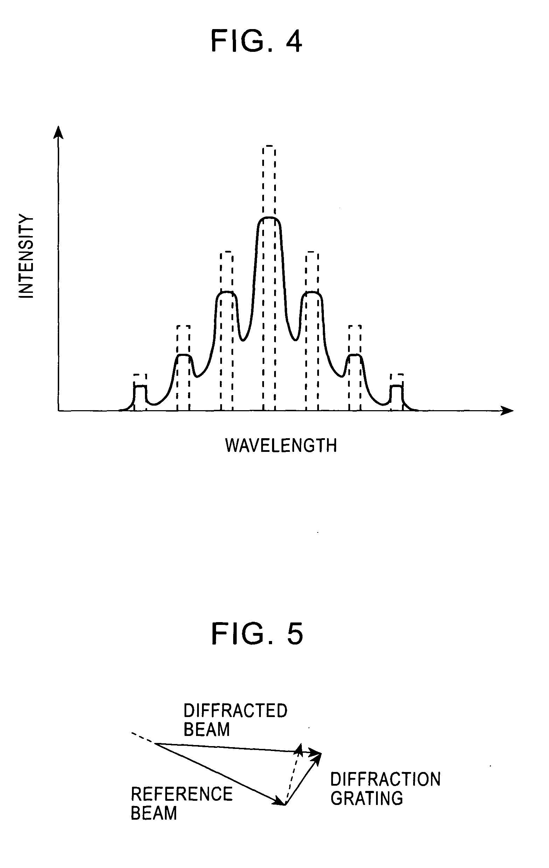

The embodiments of the present invention will now be described by referring to the accompanying drawings. First of all, a first embodiment of the present invention will be described. Fig. 1 is a schematic view of the structure of a holographic memory device according to the first embodiment of the present invention. Fig. 2 is a cross-sectional view of a semiconductor laser according to the first embodiment of the present invention. Fig. 3 is an enlarged cross-sectional view of a cleavage plane and its vicinity. Fig. 4 is a graph showing the spectrum of laser light emitted from the semiconductor laser according to the first embodiment. Fig. 5 is a vector representation, showing correction of deviation of an incident angle by changing the wavelength of a reference beam.

Referring to Fig. 1, a read-only holographic memory device 1 of the first embodiment includes a holographic storage medium 10, a laser oscillator or semiconductor laser 20, a lens 30, a lens 40, and a CCD 50. The semiconductor laser 20 emits a reference beam onto the holographic storage medium 10. The lens 30 collimates the laser light from the semiconductor laser 20, and the lens 40 forms an image with the light diffracted by the holographic storage medium 10. The CCD 50 detects the diffracted light composing the image formed by the lens 40, thereby reproducing information.

According to the first embodiment, interference patterns are previously recorded as diffraction gratings on the holographic storage medium 10. The interference patterns are formed through the interference between a signal beam with page-based encoded information and a reference beam. The holographic storage medium 10 is disposed in the holographic memory device 1. Alternatively, the holographic storage medium 10 may be a removable disc to be inserted into the holographic storage medium 10. The semiconductor laser 20 oscillates multiple mode laser light. More specifically, the multiple modes contain a main mode with the highest intensity of laser light and a number of side modes at certain wavelength intervals. As the wavelength of the side modes is remote from the wavelength of the main mode, the intensity of laser light is attenuated.

The structure of the semiconductor laser 20 according to the first embodiment will be described in detail hereinbelow. Referring to Fig. 2, the structure of the semiconductor laser 20 is substantially the same as that of a regular semiconductor laser. That is, an active layer 21 is disposed between a p-type cladding layer 22 and an n-type cladding layer 23. Outside these layers, a substrate 24, an insulating layer 25, a negative electrode 26, and a positive electrode 27 are also provided. The side faces of the active layer 21 are cleavage planes 21a. These cleavage planes 21a function as reflectors by utilizing the difference in refractive index and the semiconductor laser 20 serves as a resonator. That is, having been reflected at the cleavage planes 21a, light is resonated and amplified in the active layer 21. When the amplified light exceeds a threshold, laser light is emitted.

The cleavage planes of a regular semiconductor laser are flat so that the cleavage planes oscillate laser light with a low half-width and a uniform wavelength at high intensity. By contrast, the cleavage planes 21a according to the first embodiment have irregularities, as shown in Fig. 3. A typical semiconductor laser is fabricated in such a manner that cladding layers, an active layer, and electrodes are laminated on a substrate having an area large enough for providing several tens of semiconductor lasers and the resulting structure is cut into individual semiconductor lasers. Therefore, by cutting the semiconductor lasers so as to have rough surfaces, the cleavage planes 21a have irregularities.

Since the irregularities are provided on the cleavage planes 21a, the laser light emitted from the semiconductor laser 20 shows a continuous wavelength distribution between the main mode and the side modes. That is, a wavelength $\lambda$ of laser light emitted from the active layer 21 satisfies the following equation (1):

$$\lambda_m = \frac{2L}{m} \qquad (1)$$

wherein L is the length between the cleavage planes 21a and m is a positive integer.

According to the first embodiment, due to the irregularities of the cleavage planes 21a, the length L slightly differs depending on position in the cleavage planes 21a. Accordingly, the laser light emitted from the semiconductor laser 20 has different wavelengths in accordance with the length L according to equation (1). Thus, as shown in Fig. 4, although the intensity of light is reduced, laser beams with wavelengths in the vicinity of the wavelength of the main mode with the highest intensity can be output in side modes, whereby the half-widths of the main mode and the side modes become larger. When the cleavage planes 21a are not provided, the wavelength distribution of the main mode and the side modes is generally not continuous. According to the first embodiment, however, the wavelength distribution of the laser light is continuous from the main mode to the side modes since laser light of the main mode and the side modes have larger half-widths than the case where no cleavage plane 21a is provided. When the difference between the highest intensity of the light at the main mode and the intensity of light at the side mode that is continuous with that of the main mode is smaller than or equal to 20 dB, the laser light has a sufficient intensity at the wavelengths between the main mode and the two adjacent side modes.

Now, it will be described how the wavelength and incident light of the reference beam are related to the occurrence of diffracted light. When a reference beam incident on the diffraction grating on the holographic storage medium 10 is diffracted, the relationship between an incident angle or reflection angle θ and the wavelength λ is represented by the following equation (2):

$$n\lambda = 2d \sin \theta \qquad (2)$$

wherein n is a positive integer and d is an interplanar spacing.

When the positional relationship between the reference beam and the holographic storage medium 10 becomes slightly out of balance and thus the incident angle θ of the reference beam is deviated, the deviation can be corrected by changing the wavelength of the reference beam. According to the first embodiment, since laser light having a continuous wavelength distribution is emitted onto the holographic storage medium 10 as a reference beam, one of the light beams in accordance with equation (2) is diffracted to reproduce the information recorded on the holographic storage medium 10. This is represented by vectors in Fig. 5. When the angle between a reference-beam vector and a diffraction-grating vector is large, the length of the reference-beam vector is reduced. That is, by making the wavelength of the reference beam short, a diffracted-beam vector identical to the signal-beam vector used when recording information is reproduced by the reference-beam vector and the diffraction-grating vector.

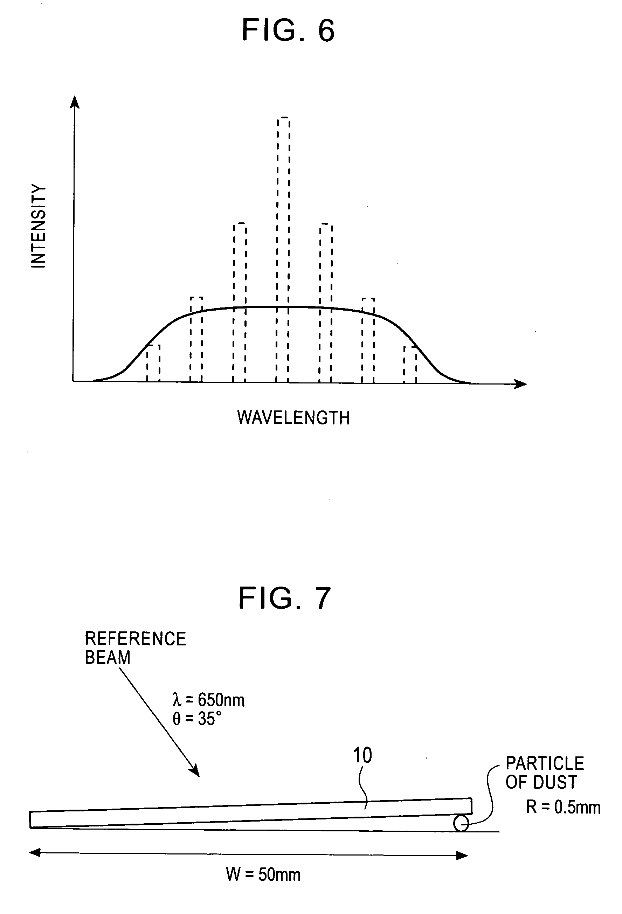

The half-width for each mode is determined based on the size of the irregularities of the cleavage planes 21a. When the size of the irregularities is large, the length L greatly differs depending on position. Accordingly, the half-width for each mode becomes wide. Therefore, alternatively, large irregularities may be formed on the cleavage planes 21a such that the laser light has a large half-width for each mode, thereby emitting laser light having a smooth flat and broad wavelength distribution in which all of the wavelengths are continuous, as shown in Fig. 6. Accordingly, laser light having substantially the same intensity in a certain wavelength range is emitted on the holographic storage medium 10 so that the output of the diffracted light becomes substantially uniform. In this case, the intensity of laser light from the semiconductor laser 20 is necessarily high.

In holographic recording, sometimes information is recorded by multiplexing the wavelengths of laser light. In this case, to avoid interference with other multiplexed laser light, the wavelength range of the laser light having the continuous wavelength distribution is required to be smaller than each of the intervals of the wavelengths of the multiplexed laser light.

Now, correction of the deviation of an incident angle by changing wavelengths will be described. Referring to Fig. 7, when a reference beam with a wavelength λ of 650 nm is incident on the holographic storage medium 10 having a width W of 50 mm at an incident angle θ of 35 degrees, a particle of dust with a diameter R of 0.5 mm resides under the holographic storage medium 10. In this case, the incident angle θ is reduced by 0.01 degrees due to the particle of dust and thus the amount of change in wavelength is about -0.16 nm according to equation (2). Thus, when emitted laser light includes light beams with the wavelength shorter than the wavelength of the main mode by about 0.16 nm, the light beam having the wavelength shorter than that of the main mode by 0.16 nm is diffracted by the holographic storage medium 10 to reproduce the information recorded on the holographic storage medium 10.

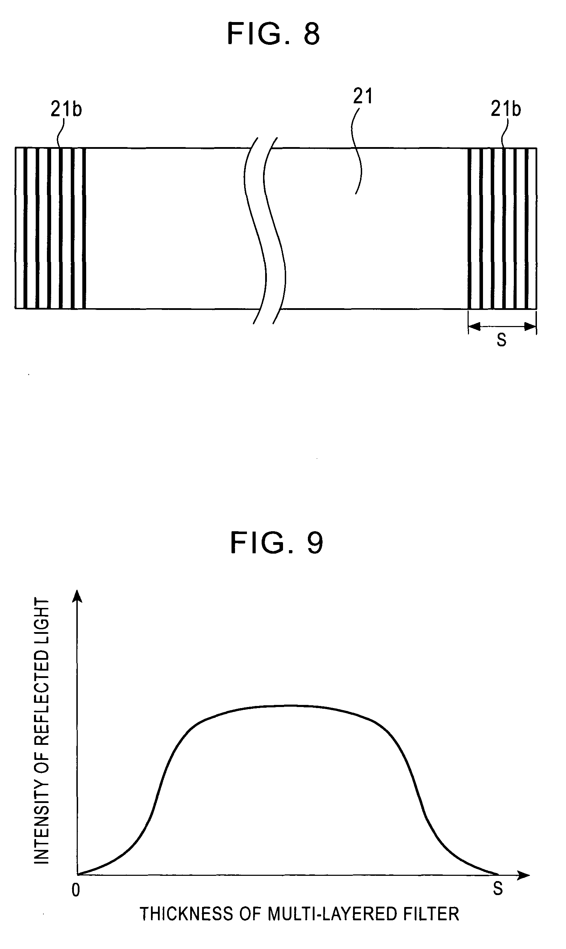

In the first embodiment described above, due to the irregularities of the cleavage planes 21a, the length of the resonator is changed depending on position so that the half-width of laser light for each mode is large. In a second embodiment of the present invention, the length of the resonator is made to differ depending on position in a different manner in order to have a large half-width of the laser light for each mode. Fig. 8 is an enlarged cross-sectional view of an active layer of a semiconductor laser according to the second embodiment. Fig. 9 is a graph showing the intensity of light reflected by a multi-layered filter according to the second embodiment.

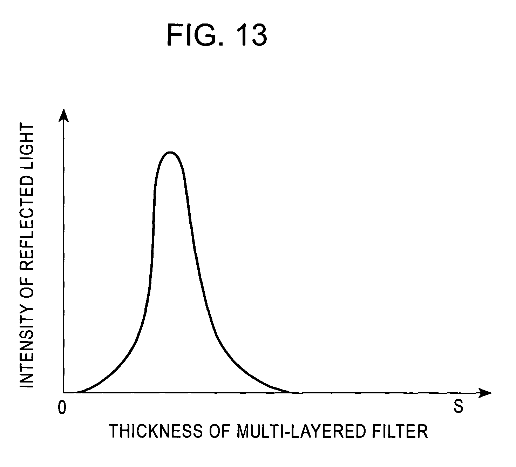

The structure of a holographic memory device 1 according to the second embodiment is substantially the same as that of the first embodiment. The holographic memory device 1 of the second embodiment includes a holographic storage medium 10, a semiconductor laser 20, a lens 30, a lens 40, and a CCD 50. Multi-layered filters 21b are disposed on both sides of the active layer 21 and function as reflectors. The semiconductor laser 20 serves as a resonator. In a known reflector composed of a multi-layered filter, the multi-layered filter is formed such that the maximum intensity of the reflected light is 30% or less than the entire thickness S of the multi-layered filter and such that the reflected light has a narrow intensity distribution near the maximum intensity, as shown in Fig. 13. By contrast, as shown in Fig. 9, laser light of the second embodiment has a flat and broad intensity distribution of reflected light with the highest intensity around the middle of the entire thickness S, and the intensity of reflected light gradually changes as the thickness of the multi-layered filter changes. Modification of the structure and thickness of the multi-layered filter allows the multi-layered filter to have a predetermined intensity distribution of reflected light. Thus, the multi-layered filters 21b can be fabricated to exhibit the above-described intensity distribution of reflected light.

The multi-layered filters 21b are constructed to have the flat and broad intensity distribution with the highest intensity around the middle of the entire thickness S. With this flat and broad intensity distribution, the intensity of reflected light gradually changes along the thickness direction of the multi-layered filter. Accordingly, the resonator has different lengths depending on position, similar to the first embodiment, and thus the semiconductor laser 20 emits laser light with various wavelengths. By this structure, although the intensity of light is reduced, laser beams with wavelengths in the vicinity of the wavelength of the main mode with the highest intensity can be output in side modes, whereby the half-widths of the main mode and the side modes become larger. That is, wavelengths of laser beams become continuous between the main mode and the side modes in the wavelength distribution. Alternatively, the length of the resonator may be varied when each multi-layered filter 21b has a thickness 1.5 times thicker than the minimum thickness to exhibit a predetermined intensity of reflected light necessary for the resonator and also has the same intensity of reflected light as the minimum thickness.

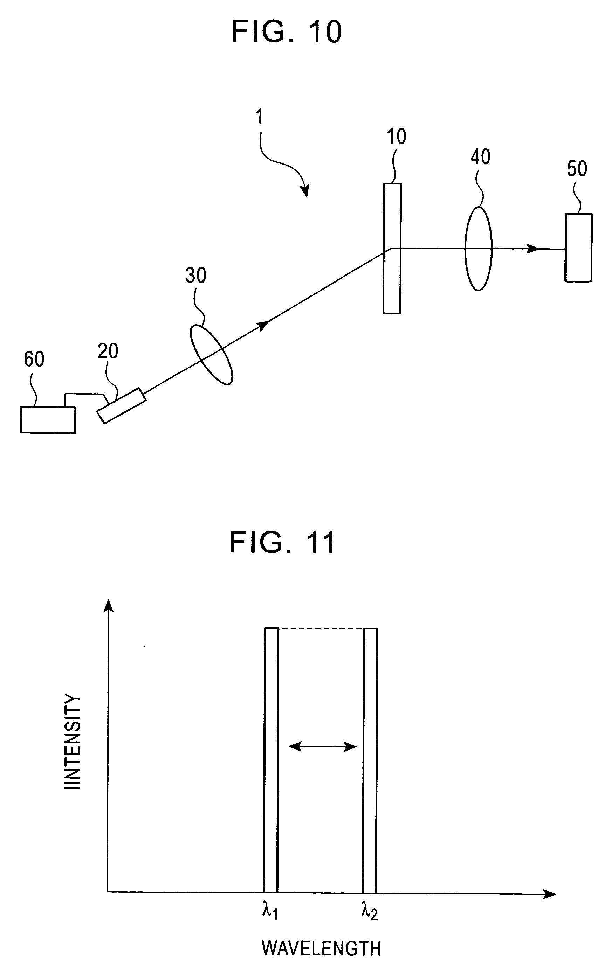

In the first and second embodiments, by making the half-width for each mode large, a reference beam with a continuous wavelength distribution is incident on the holographic storage medium 10, whereby deviation of the incident angle with respect to the holographic storage medium 10 is corrected. According to a third embodiment, deviation of the incident angle is corrected in a different manner. Fig. 10 is a schematic view of the structure of a holographic memory device according to the third embodiment of the present invention. Fig. 11 is a graph showing the spectrum of laser light emitted from a semiconductor laser according to the third embodiment.

The structure of a holographic memory device 1 according to the third embodiment is substantially the same as those of the first and second embodiments. The holographic memory device 1 of the third embodiment includes a holographic storage medium 10, a semiconductor laser 20, a lens 30, a lens 40, and a CCD 50. According to the third embodiment, the cleavage planes 21a with the irregularities of the first embodiment are not provided at the semiconductor laser 20. The side faces of the semiconductor laser 20 are flat so that the length of the resonator is substantially the same, like a regular semiconductor laser. A holographic memory device 1 of the third embodiment includes a current modulator 60. Electric current is supplied to the semiconductor laser 20 through the current modulator 60. It is known that by changing a current input to a semiconductor laser, laser light emitted from the semiconductor laser is slightly changed. The current modulator 60 generates a current with an amplitude changing in a fixed range such as a current with a sine wave. The modulated current is supplied to the semiconductor laser 20 and thus the wavelength of laser light is changed in a fixed range. The current modulator 60 is an FET modulator, for example. Alternatively, the multi-layered filters 21b of the second embodiment may be provided on the side faces of the active layer 21 so that the multi-layered filters 21b function as reflectors. In this case, however, a regular intensity distribution of reflected light for a known semiconductor laser as shown in Fig. 13 is employed, not the flat and broad intensity distribution described in the second embodiment.

Assuming that an oscillation during which laser light changes from a minimum wavelength $\lambda 1$ to a maximum wavelength $\lambda 2$ is one oscillation, the laser light emitted from a laser oscillator has a wavelength band from the minimum wavelength $\lambda 1$ to the maximum wavelength $\lambda 2$, as shown in Fig. 11. Accordingly, when the positional relationship between the reference beam and the holographic storage medium 10 is slightly out of balance and thus the incident angle $\theta$ of the reference beam is deviated, one of the light beams in accordance with equation (2) is diffracted to reproduce the information recorded on the holographic storage medium 10. In order to ensure that the laser light is diffracted, the laser light needs to be emitted onto the holographic storage medium 10 at least for one period of current change.

In the third embodiment, the wavelength of the laser light emitted from the semiconductor laser 20 is varied by modulating the current supplied to the semiconductor laser 20. Alternatively, the wavelength of laser light may be modulated by using a DBR laser or external cavity laser as the semiconductor laser.

The present invention has been described by referring to the preferred embodiments. In the above-described embodiments, the read-only holographic memory device is exemplified to describe the present invention. Alternatively, the present invention may be applied to a holographic memory device capable of both writing and reading.

**Claims**

1. A holographic memory device (1) comprising a laser oscillator (20) for emitting multimode laser light to be incident on a holographic storage medium (10), wherein the laser light of a main mode has a half-width such that the wavelength distribution of the main mode is continuous with the wavelength distributions of the two adjacent side modes and such that the laser light has a continuous wavelength distribution over the main mode and all the side modes.

2. The holographic memory device (1) according to claim 1, wherein the laser oscillator (20) comprises a light resonator including reflectors, the reflectors having irregularities on the surfaces thereof so that the length of the resonator differs depending on position, and

wherein light is resonated depending on the different lengths of the resonator, whereby wavelength bands at the main mode and the side modes are increased.

3. The holographic memory device (1) according to claim 1, wherein the laser oscillator (20) comprises a light resonator including multi-layered filters (21b) functioning as reflectors, each of the multi-layered filters (21b) having a flat and broad intensity distribution of reflected light along the thickness direction of the multi-layered filter so that the length of the resonator differs depending on position, and

wherein light is resonated depending on the different lengths of the resonator, whereby wavelength bands at the main mode and the side modes are increased.

4. The holographic memory device (1) according to claim 1, wherein the laser oscillator (20) comprises a light resonator including multi-layered filters (21b) functioning as reflectors, each of the multi-layered filters (21b) having a thickness 1.5 times larger than or equal to a minimum thickness at which the multi-layered filter exhibits a predetermined intensity of reflected light so that the length of the resonator differs depending on position, and

wherein light is resonated depending on the different lengths of the resonator, whereby wavelength bands at the main mode and the side modes are increased.

5. The holographic memory device (1) according to any one of claims 1 to 4, wherein the difference between the intensity of the main mode and the intensity of the adjacent side modes is less than or equal to 20 dB, the intensity of the main mode being the highest intensity of the laser light.

6. A holographic memory device (1) comprising a laser oscillator (20) for emitting multimode laser light to be incident on a holographic storage medium (10), wherein the laser light has a flat and broad wavelength distribution in which the wavelength distribution of a main mode and the wavelength distributions of side modes are continuous.

7. The holographic memory device (1) according to claim 6, wherein the laser oscillator (20) comprises a light resonator including reflectors, the reflectors having irregularities on the surfaces thereof so that the length of the resonator differs depending on position, and

wherein light is resonated depending on the different lengths of the resonator, whereby wavelength bands at the main mode and the side modes are increased.

8. A holographic memory device (1) comprising:

a laser oscillator (20) for emitting multimode laser light to be incident on a holographic storage medium (10); and
a current modulator (60) for generating a current whose amplitude changes in a predetermined range, wherein
the current modulated by the current modulator (60) is supplied to the laser oscillator (20) to change the wavelength of the laser light in a predetermined range and the laser light with the modulated wavelength is emitted onto the holographic storage medium (10).

9. The holographic memory device (1) according to any one of claims 1 to 8, wherein information is recorded on the holographic storage medium (10) by wavelength multiplexing, and the wavelength range of the laser light emitted from the laser oscillator (20) is shorter than each of the intervals of the wavelengths of laser beams used for recording the information by multiplexing.

FIG. 1

# FIG. 2

# FIG. 3

# FIG. 4

INTENSITY

WAVELENGTH

# FIG. 5

DIFFRACTED
BEAM

REFERENCE
BEAM

DIFFRACTION
GRATING

# FIG. 6

INTENSITY

WAVELENGTH

# FIG. 7

REFERENCE
BEAM

$\lambda = 650nm$
$\theta = 35°$

10

PARTICLE
OF DUST

$R = 0.5mm$

$W = 50mm$

# FIG. 8

# FIG. 9

# FIG. 10

# FIG. 11

FIG. 12A

SIGNAL BEAM

DIFFRACTION
GRATING

REFERENCE
BEAM

FIG. 12B

DIFFRACTED
BEAM

DIFFRACTION
GRATING

REFERENCE
BEAM

FIG. 12C

DIFFRACTION
GRATING

REFERENCE
BEAM

# FIG. 13